(19) Europäisches Patentamt
European Patent Office
Office européen des brevets

(11) **EP 2 487 708 B1**

(12) **FASCICULE DE BREVET EUROPEEN**

(45) Date de publication et mention
de la délivrance du brevet:
**08.07.2015 Bulletin 2015/28**

(51) Int Cl.:
*H01L 21/28* *(2006.01)*      *H01L 29/423* *(2006.01)*
*H01L 29/788* *(2006.01)*

(21) Numéro de dépôt: **12154295.5**

(22) Date de dépôt: **07.02.2012**

(54) **Procédé d'obtention d'un réseau de plots nanométriques**

Verfahren zum Erstellen eines Netzes aus nanometrischen Kontakten

Method for obtaining a network of nanometric terminals

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **11.02.2011 FR 1151127**

(43) Date de publication de la demande:
**15.08.2012 Bulletin 2012/33**

(73) Titulaires:
• **Commissariat à l'Énergie Atomique
et aux Énergies Alternatives
75015 Paris (FR)**
• **Centre National de la Recherche Scientifique
75794 Paris Cedex 16 (FR)**
• **Université Joseph Fourier
38041 Grenoble Cedex 9 (FR)**

(72) Inventeurs:
• **Gay, Guillaume
38000 GRENOBLE (FR)**
• **Baron, Thierry
38120 SAINT EGREVE (FR)**
• **Jalaguier, Eric
38140 SAINT MARTIN D'URIAGE (FR)**

(74) Mandataire: **Hautier, Nicolas
Cabinet Hautier
20, rue de la Liberté
06000 Nice (FR)**

(56) Documents cités:
EP-A1- 2 088 618        EP-A1- 2 381 471
US-A1- 2004 256 662     US-A1- 2007 114 572

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

DOMAINE TECHNIQUE DE L'INVENTION

La présente invention concerne la réalisation de nanocristaux à caractère métallique notamment en vue de former la grille flottante de transistors MOSFET utilisés par les mémoires non-volatiles de type EEPROM et FLASH.

ÉTAT DE LA TECHNIQUE

La miniaturisation toujours plus poussée des dispositifs produits par l'industrie de la microélectronique demande de pouvoir réaliser les composants de base, essentiellement des transistors, qui se mesurent désormais en dizaines de nanomètres (nm = $10^{-9}$ mètre). On atteint alors les limites de nombreuses techniques utilisées par cette industrie notamment celles de la photolithographie. Pour pouvoir définir à la surface d'un substrat semi-conducteur, avec une très grande précision, des motifs toujours plus petits la photolithographie doit mettre en oeuvre des moyens de plus en plus sophistiqués comme, par exemple, l'utilisation de longueurs d'ondes plus courtes, jusqu'à l'ultraviolet, pour l'insolation de résines photosensibles à travers des masques reproduisant les motifs, ou une insolation en immersion pour réduire les problèmes de diffraction. La lithographie par faisceau d'électrons est aussi employée quand il s'agit de graver des motifs de taille nanométrique. Technique qui est cependant intrinsèquement lente et coûteuse puisqu'il faut, avec un faisceau d'électrons, insoler successivement chaque motif de chaque dispositif produit. D'une grande précision la lithographie électronique est en pratique le plus souvent réservée à la réalisation des masques eux-mêmes.

Une autre voie a cependant été aussi explorée depuis plus d'une dizaine d'année pour former des motifs de petites tailles. Voie qui ne nécessite pas d'avoir recours à la photolithographie. Il s'agit d'utiliser la propriété qu'ont certains matériaux de pouvoir s'auto organiser s'ils sont placés dans des conditions adéquates. Ils peuvent alors spontanément produire une structure de motifs nanométriques qui peut être utilisée pour transférer un réseau de motifs correspondants dans le dispositif semi-conducteur à produire sans que ces motifs aient eu besoin d'être définis par lithographie ou par aucun autre moyen extérieur autre que par la création des conditions environnementales propices à leur formation, notamment le respect de la température et de la durée de l'opération qui permettront au matériau de s'auto organiser effectivement.

Cette technique a en particulier été utilisée pour réaliser la grille flottante de transistors MOSFET, de l'anglais : « Metal Oxide Semiconductor Field Effect Transistor », c'est-à-dire « transistor à effet de champs de type métal-oxyde-semiconducteur » qui servent à fabriquer des mémoires non-volatiles de type EEPROM, de l'anglais : « Electrically Erasable Programmable Read Only Memory », c'est-à-dire : « mémoire à lecture seule programmable et effaçable électriquement ». Ce type de mémoires inclut notamment les mémoires dites « FLASH » qui connaissent un très grand succès en particulier sous la forme de clés USB, de l'anglais « Universal Serial Bus » soit bus informatique universel en transmission série, en raison de la très grande densité d'intégration qu'elles permettent d'obtenir ainsi que pour la facilité avec laquelle elles peuvent être réécrites un très grand nombre de fois tout en étant, comme les disques durs d'ordinateurs, non-volatiles.

Cette très importante propriété est obtenue par la création d'une grille dite flottante incluse dans l'oxyde de la structure métal-oxyde-semiconducteur de transistors MOSFET. La grille flottante est alors utilisée pour capturer des électrons qui y resteront piégés dans des conditions normales de lecture de la mémoire, et aussi en l'absence d'alimentation, d'où la non volatilité. Ainsi, en fonction du fait qu'on aura permis à la grille flottante d'un transistor de piéger un certain nombre de porteurs ou pas, le niveau électrique du seuil de conduction du transistor MOSFET sera plus ou moins élevé ce qui permettra d'y lire au moins deux niveaux de conduction différents, conducteur ou non, et donc d'y stocker au moins un bit d'information : 0 ou 1.

La programmation d'un point mémoire et son effacement, c'est-à-dire le piégeage de charges et leur évacuation de la grille flottante fait appel à au moins deux techniques universellement employées dans ce domaine. D'une part, l'injection d'électrons chauds, c'est-à-dire ayant une forte énergie, pour charger la grille flottante. D'autre part l'effet tunnel, effet quantique obtenu en appliquant une haute tension sur la grille métallique de commande du transistor MOSFET pour rejeter, à travers la mince couche d'oxyde sous jacente, généralement qualifiée de couche tunnel, les électrons de la grille flottante dans le canal de conduction entre drain et source d'où ils sont évacués. Ces conditions sont obtenues en appliquant des tensions particulières sur les trois électrodes des transistors : source, drain et grille de commande. Combinaisons de tensions qui n'apparaissent évidemment pas en lecture pour ne pas perturber la programmation du transistor lu.

Quels que soient les techniques et moyens employés pour lire, programmer et effacer un point mémoire et quelle que soit l'architecture de leur organisation globale qui a fait notamment le succès des mémoires FLASH, un enjeu commun aux mémoires utilisant des transistors à grille flottante est la capacité de pouvoir programmer plus de deux niveaux de conduction. C'est-à-dire de pouvoir contrôler le piégeage des charges dans la grille flottante d'une façon reproductible et plus fine que la simple programmation d'un seul seuil de conduction dans la plage de tension utilisée normalement en lecture de façon, à pouvoir, par exemple, discriminer quatre niveaux différents et donc d'y stocker deux bits d'information : 00, 01, 10 et 11. Ce qui a pour effet, dans cet exemple, de pouvoir doubler la capacité de la mémoire correspondante sans avoir à doubler le nombre de transistors. L'augmentation et la reproductibilité dans le cadre d'un processus industriel de la fenêtre de programmation des grilles flottantes sont des facteurs essentiels à l'obtention de mémoires non-volatiles, par exemple de type FLASH, toujours plus denses.

Ainsi, pour permettre la réalisation de mémoires non-volatiles toujours plus denses et plus performantes, on comprend qu'une attention toute particulière a été apportée à la conception des grilles flottantes des transistors MOSFET utilisés par ces mémoires. Alors que traditionnellement les grilles flottantes étaient constituées d'une couche continue, généralement faite de silicium polycristallin, noyée dans une couche isolante d'oxyde de silicium, on s'oriente désormais vers la réalisation de grilles flottantes faites de sites de piégeages discrets.

La réalisation de ces sites discrets de piégeage se fait sous la forme de plots de taille nanométrique ou nanocristaux. Comme mentionné en introduction, il est alors particulièrement adapté d'avoir recours à l'utilisation d'un matériau capable de s'auto organiser pour définir la taille, typiquement quelques dizaines de nanomètres, et la densité de ces sites qui doivent être créés sur toute la surface de la grille de ces transistors MOSFET.

US 2004/0256662 décrit un procédé d'obtention d'une mémoire non-volatile.

Dans de nombreuses applications, les performances des dispositifs utilisant ces plots nanométriques sont étroitement liées au comportement électrique des plots. Il est ainsi nécessaire de maîtriser aussi précisément que possible le comportement électrique des plots.

En effet, un comportement électrique non maîtrisé des plots conduit par exemple à une réduction ou à un déplacement de la fenêtre de programmation d'une cellule mémoire comprenant un transistor MOSFET dont la grille comprend des plots.

Par ailleurs, une maîtrise médiocre du comportement électrique conduit souvent à une faible reproductibilité des performances des dispositifs intégrant un réseau de plots nanométriques.

Le problème que se propose de résoudre l'invention est donc d'améliorer la maîtrise du comportement des plots d'un réseau de plots nanométriques.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Les objectifs ci-dessus sont atteints par l'invention qui décrit un procédé d'obtention d'un réseau de plots nanométriques pour dispositif microélectronique, comprenant les étapes suivantes :

- le dépôt d'une couche de silicium sur un substrat,

- la formation au dessus de la couche de silicium d'une couche en un matériau capable de s'auto organiser à l'intérieur de laquelle au moins un polymère forme sensiblement des cylindres organisés en un réseau au sein d'une matrice,

- la formation de motifs dans la couche en un matériau capable de s'auto organiser par élimination desdits cylindres,

- la formation d'un masque par transfert desdits motifs,

- l'obtention de plots de silicium dans la couche de silicium par gravure avec le masque,

- la siliciuration des plots de silicium comprenant le dépôt d'une couche de métal.

Dans le cadre du développement de l'invention il a été identifié que la variabilité du comportement électrique des dispositifs utilisant des plots nanométriques provient d'une faible maîtrise de l'évolution de ces plots au cours de l'obtention du dispositif.

Notamment il s'est avéré que les plots métalliques utilisés dans les grilles flottantes des transistors sont bien souvent dégradés par les étapes ultérieures de finalisation du dispositif tel qu'un transistor dans lequel ces plots sont intégrés. Ces étapes ultérieures mettent en jeu des températures élevées qui peuvent modifier le comportement électrique voire la structure de certains plots. L'invention prévoit l'obtention de plots siliciurés, ces plots ne sont donc pas uniquement métalliques. Il s'est avéré que leur comportement est beaucoup moins sensible aux élévations de température que celui des plots purement métalliques. Le comportement des plots obtenus selon l'invention demeure par conséquent stable. Le procédé selon l'invention permet ainsi d'améliorer la maîtrise du comportement des plots nanométriques.

En outre et de manière particulièrement avantageuse, le procédé selon l'invention permet d'améliorer très significativement la maîtrise notamment de la hauteur des plots par rapport aux procédés connus d'obtention de plots nanométriques.

Or, dans le cadre du développement de l'invention il a été identifié que la variabilité de comportement électrique de plots nanométriques siliciurés provient bien souvent d'un manque d'homogénéité des phases de siliciuration possibles entre silicium et métal. Il a également été identifié que ce manque d'homogénéité provient de la variation du rapport quantité de métal apporté sur quantité de silicium contenu dans chacun des plots. Pour maîtriser ce rapport l'invention dévoile un procédé qui réduit la dispersion en particulier en hauteur donc en volume des nanocristaux avant siliciuration ainsi qu'en espacement. La dispersion en taille des nanocristaux est réduite. La quantité de métal à apporter peut ainsi être précisément déterminée et le rapport quantité de métal apporté sur quantité de silicium contenu dans chacun des plots est mieux maîtrisé. Il en résulte des plots dont le comportement électrique est amélioré et plus prévisible.

L'invention permet ainsi d'améliorer significativement, les performances et la reproductibilité des dispositifs intégrant ces nanocristaux.

Elle permet par exemple un contrôle fin et reproductible du piégeage des charges dans une grille flottante. Elle est par conséquent particulièrement bien adaptée à l'obtention de cellules mémoires permettant de programmer plusieurs bits d'information.

De manière facultative, l'invention comprend en outre au moins l'une quelconque des caractéristiques optionnelles suivantes :

De préférence, la couche de silicium est une couche de silicium polycristallin. Alternativement, la couche de silicium est une couche de silicium amorphe ou monocristallin.

L'épaisseur de métal est déterminée en fonction au moins du volume desdits plots nanométriques de sorte à assurer une siliciuration complète de chacun des plots.

Le substrat comprend au moins à sa surface de l'oxyde de silicium. De préférence, le substrat comprend un substrat de base surmonté d'une couche d'oxyde de silicium. Préférentiellement, le substrat de base est en silicium. Plus généralement le substrat de base est en un matériau semi conducteur.

La couche en un matériau capable de s'auto organiser est une couche comprenant des copolymères aptes à s'auto-organiser en un réseau hexagonal plan de cylindres de section sensiblement circulaire ou polygonale dans une matrice. Avantageusement cette structure permet d'obtenir une bonne homogénéité de comportement des plots. De préférence, les cylindres s'étendent sensiblement verticalement. Ils s'étendent de préférence sur toute l'épaisseur de la couche en un matériau capable de s'auto organiser.

La couche en un matériau capable de s'auto organiser est une couche comprenant un copolymère diblocs dont l'un des polymères forme lesdits cylindres et dont l'autre des polymères forme la matrice.

Avantageusement la couche en un matériau capable de s'auto organiser est une couche comprenant l'un parmi : le polystyrène-poly methylmethacrylate (PS-PMMA), le polystyrène-polyvinylpyridine (PS-PVP), le polystyrène-polyethylene oxide (PS-PEO). De préférence, la couche en un matériau capable de s'auto organiser est une couche comprenant du PS-PMMA (polystyrène-polymethylmethacrylate) formant des cylindres de PMMA (polymethylmethacrylate) dans une matrice de PS (polystyrène) et dans lequel l'étape de formation des motifs comprend l'élimination sélective des cylindres de PMMA par rapport à la matrice de PS (polystyrène).

Le masque est un masque dur. On désigne masque dur un masque résistant à la gravure, typiquement à une gravure plasma. Un masque dur recouvre en partie au moins des couches sous jacentes. Il protège ainsi de la gravure les zones appartenant aux couches que le masque dur recouvre et qui sont situées au droit du masque. Les zones non recouvertes par le masque peuvent être gravées.

De préférence, la formation du masque dur est obtenue par une étape de dépôt d'une couche de masquage au moins dans les motifs de la couche en un matériau capable de s'auto organiser et par une étape de retrait du matériau capable de s'auto organiser en dehors des motifs.

La couche de masquage est une couche résistant à une étape de gravure de sorte à protéger de la gravure des couches sous jacentes à celle de la couche de masquage et à transférer les motifs du masque dur dans ces couches sous jacente.

De préférence, la couche de masquage est une couche prise parmi : une couche d'alumine, une couche d'oxyde de silicium (Si02), une couche de nitrure de silicium (Si3N4), une couche de carbone amorphe,

Optionnellement, l'étape de formation du masque dur comprend une étape dépôt d'une couche de masquage par déposition de couches atomique. Par exemple, l'étape de formation du masque dur est effectuée de sorte que le masque dur présente une épaisseur d'environ 5 nanomètres.

Selon une variante avantageuse, l'étape de retrait du matériau capable de s'auto organiser comprend une étape de soulèvement habituellement désignée par son vocable anglais lift-off.

De préférence, préalablement à la formation de la couche en un matériau capable de s'auto organiser, le procédé comprend une étape de formation d'une couche de neutralisation en un copolymère statistique. L'étape de formation de motifs dans la couche en un matériau capable de s'auto organiser conduit également à obtenir lesdits motifs dans la couche de neutralisation. En outre l'étape de soulèvement comprend une première étape de soulèvement par gravure de la couche en un matériau capable de s'auto organiser et de la couche de neutralisation et une deuxième étape de soulèvement consistant à soulever la couche de masquage. Cette deuxième étape de soulèvement est entraînée par la première étape de soulèvement. De préférence, la gravure est une gravure plasma.

Selon un mode de réalisation avantageux, le copolymère statistique est du Polystyrene-r-polymethylmethacrylate (PS-r-PMMA).

De préférence, le procédé comprend, préalablement à la formation d'une couche en un matériau capable de s'auto organiser, une étape de formation d'une couche d'oxyde de silicium (SiO2) recouvrant la couche de silicium.

La couche de métal est constituée au moins partiellement d'un matériau pris parmi : le platine, le nickel, le titane (Ti), le vanadium (V), le chrome (Cr), le manganèse (Mn), le fer (Fe), le cobalt (Co), le molybdène (Mo), le palladium (Pd), le tantal (Ta), le tungstène (W).

Selon des variantes privilégiées de réalisation, la couche de métal comprend au moins partiellement du platine ou du nickel. De préférence, la couche de métal comprend uniquement du platine ou du nickel. Le platine (Pt) et/ou le nickel (Ni) ont chacun au moins deux phases de siliciuration possibles. L'épaisseur de la couche de métal déposée est calculée pour obtenir que la siliciuration des plots soit complète dans une seule des phases de siliciuration possibles.

Selon un mode de réalisation, le dépôt de métal est un dépôt non-conforme obtenu par déposition physique en phase vapeur (PVD). Selon un autre mode de réalisation, le dépôt de métal est un dépôt conforme obtenu par déposition chimique en phase vapeur (CVD).

Avantageusement, l'épaisseur de la couche de métal est calculée en fonction de la conformité ou non du dépôt métallique et de la structure du réseau de plots obtenu par auto organisation : forme des plots, arrangement, taille, hauteur et espacement.

Selon un mode de réalisation, le métal restant après siliciuration dans la phase PtSi ou NiSi est dissout avec de l'eau régale.

Selon un autre objet de l'invention, on prévoit un procédé d'obtention d'un dispositif semi conducteur comportant un réseau de plots nanométriques siliciurés réalisé en mettant en oeuvre le procédé selon l'une quelconque des caractéristiques précédentes.

L'invention a également pour objet un dispositif microélectronique comportant un réseau de plots nanométriques siliciurés réalisé en mettant en oeuvre un procédé selon l'une quelconque des caractéristiques précédentes. De manière avantageuse, le dispositif obtenu par ce procédé est un transistor à effet de champs du type métal-oxyde-semiconducteur (MOSFET) comprenant une grille flottante comportant le réseau de plots nanométriques.

L'invention a également pour objet une mémoire non volatile comprenant une pluralité de transistors selon la caractéristique précédente.

On prévoit également dans le cadre de l'invention dispositif microélectronique de type transistor à effet de champs du type métal-oxyde-semiconducteur (MOSFET), comprenant une grille flottante intégrant un réseau de plots nanométriques, caractérisé en ce que les plots nanométriques sont siliciurés. De préférence, la grille flottante est située sur l'oxyde tunnel du transistor. De préférence, les plots nanométriques sont séparés de la couche formant le canal de conduction par une unique couche d'isolation. Cette couche d'isolation forme de préférence l'oxyde tunnel.

Dans le cadre du développement de l'invention il s'est avéré que les plots métalliques utilisés dans les grilles flottantes des transistors sont bien souvent dégradés par les étapes ultérieures de finalisation du dispositif tel qu'un transistor dans lequel ces plots sont intégrés. Ces étapes ultérieures mettent en jeu des températures élevées qui peuvent modifier le comportement électrique voire la structure de certains plots. L'invention prévoit l'obtention de plots siliciurés, ces plots ne sont donc pas uniquement métalliques. Il a été identifié que leur comportement est beaucoup moins sensible aux élévations de température que celui des plots purement métalliques. Le comportement des plots obtenus selon l'invention demeure par conséquent stable. Le procédé selon l'invention permet ainsi d'améliorer la maîtrise du comportement électrique des plots nanométriques, augmentant de ce fait les performances des transistors MOSFET intégrant des plots nanométriques.

L'invention a également pour objet une mémoire non volatile comprenant une pluralité de transistors selon l'invention.

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La FIGURE 1 montre, en coupe, un exemple de structure de transistor MOSFET utilisé pour la réalisation de points mémoires non-volatiles et incluant une grille flottante faite de nanocristaux siliciurés.
La FIGURE 2, qui comprend les figures 2a, 2b et 2c, décrit la partie du procédé selon l'invention dans laquelle les plots de taille nanométrique sont définis à partir d'un matériau capable de s'auto organiser.
La FIGURE 3 comprend les figures 3a à 3d qui décrivent les étapes du procédé où l'on forme les plots de silicium.

La FIGURE 4 montre une photo faite a l'aide d'un microscope à balayage électronique d'un réseau de plots de taille nanométrique réalisés avec le procédé de l'invention.

La FIGURE 5 comprend les figures 5a à 5c qui décrivent les étapes du procédé où l'on réalise la siliciuration des plots de silicium.

Les dessins joints sont donnés à titre d'exemples et ne sont pas limitatifs de l'invention.

DESCRIPTION DÉTAILLÉE DE L'INVENTION

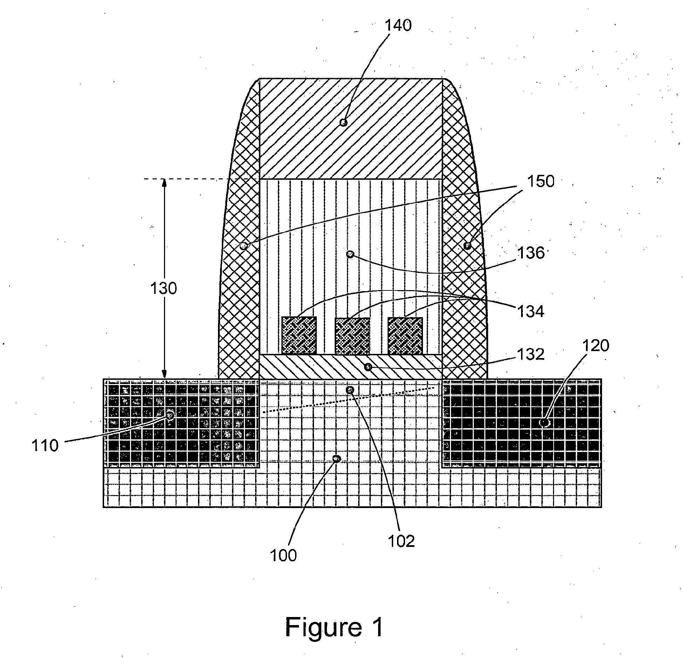

La figure 1 montre, en coupe, un exemple de structure de transistor MOSFET utilisé pour la réalisation de points mémoires non-volatiles et incluant une grille flottante faite de nanocristaux également désignés plots nanométriques.

Dans cette structure classique de transistor MOSFET, source 110 et drain 120 sont symétriques. Ils sont ici constitués de zones dopées de type N dans un substrat de base ou une couche supérieure de type P 100 d'un dispositif semi-conducteur plus complexe du genre de ceux produits par l'industrie de la microélectronique : processeurs, circuits intégrés spécialisés, etc.

La zone d'oxyde de la structure métal-oxyde-semiconducteur est constituée par les couches 130 comprises entre la grille de commande 140 à caractère métallique et le substrat de base semi-conducteur 100. Cela comprend le diélectrique de contrôle 136 incluant des plots de taille nanométriques : les nanocristaux 134 qui constituent la grille flottante, et la fine couche sous jacente 136 formant la couche d'oxyde dite tunnel 132.

On note aussi la présence d'espaceurs 150, fait d'oxyde ou de nitrure de silicium, qui servent à l'auto alignement des zones à caractère métallique constituant la grille de commande 140, déjà mentionnée, et à former les contacts électriques, non représentés, sur les électrodes source et drain du transistor. L'application d'une tension supérieure au seuil de conduction, entre grille de commande 140 et source 110 crée un canal de conduction 102, en surface du substrat de base 100, entre source et drain. Des électrons piégés dans les nanocristaux de la grille flottante 134 au cours d'une phase de programmation du point mémoire peuvent augmenter le seuil de conduction au-delà de la tension appliquée en lecture. Le transistor reste alors non conducteur ce qui permet donc de programmer et de stocker au moins deux états c'est-à-dire un bit d'information.

Comme décrit ci-après le procédé selon d'invention permet la réalisation de plots 134 de taille et volume très bien contrôlés ce qui permet d'élargir la fenêtre de programmation, et autorise la définition, d'une façon reproductible en réduisant la dispersion, de plus d'un seuil de conduction. On peut alors programmer plus d'états. Par exemple quatre, et d'une façon générale $2^n$ états, ce qui permet de stocker deux bits d'information, voire plus, dans un même transistor.

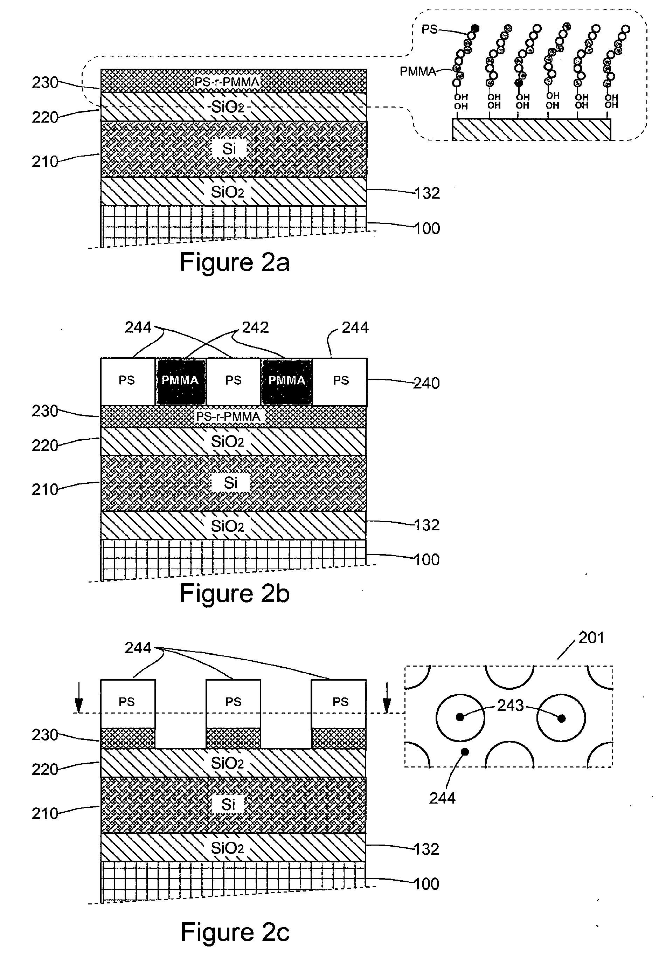

La **figure 2,** qui comprend les **figures 2a, 2b** et **2c,** décrit la partie du procédé selon l'invention dans laquelle les plots de taille nanométrique sont définis à partir d'un matériau capable de s'auto organiser.

Dans un mode préféré de mise en oeuvre de l'invention on utilise des copolymères diblocs. Un copolymère dibloc est un polymère composé de deux blocs de natures chimiques différentes reliés entre eux par une liaison covalente. Sous l'action de la température, les chaînes gagnent en mobilité et finissent par se ségréguer afin de minimiser les contacts hétérogènes entre les segments de natures chimiques différentes. Le traitement thermique de ces couches minces permet donc de créer des structures parfaitement organisées en un réseau bidimensionnel, lamellaire ou cubique centré par exemple. La longueur des chaînes de copolymère contrôle la taille et l'espacement des micro domaines qui se forment spontanément. L'épaisseur de la couche, la température et la durée de recuit agissent sur la qualité d'organisation à l'intérieur du film. Il existe de nombreuses sortes de copolymères tels que : le PS-PMMA (polystyrène-poly(methylmethacrylate)), le PS-PVP (polystyrène-polyvinylpyridine), et le PS-PEO (polystyrène-poly(ethylene oxide)). Ils font partie d'une famille de polymères globalement qualifiée de « copolymères à blocs ».

Le procédé selon l'invention s'intéresse à la création des nanocristaux eux-mêmes et n'est pas limitatif de la structure du dispositif semi-conducteur sur lesquels ils sont réalisés. Les nanocristaux pourront devoir être formés à la surface d'un substrat dans lequel on a déjà créé des motifs et un empilement de couches nécessaires à la réalisation d'un dispositif semi-conducteur particulier. Une application privilégiée du procédé de l'invention reste cependant la réalisation de grilles flottantes de mémoires non-volatiles comme cela a été discuté précédemment. Dans ce cas c'est l'oxyde tunnel 132, décrit en figure 1, qui constitue le point de départ. La couche sous-jacente est alors le substrat de base 100 là ou se forme le canal de conduction 102 entre source et drain des transistors. Toutefois, dans d'autres applications de l'invention, et d'une façon générale, la couche 132 est une couche d'oxyde pour laquelle l'invention ne fait d'hypothèse sur son mode d'obtention. Typiquement, elle est peut être déposée sur le substrat 100 ou obtenue par croissance thermique à partir de celui-ci. Ensemble, le substrat 100 et la couche d'oxyde 132 constituent le matériau de départ pour la mise en oeuvre de l'invention.

La première étape consiste à créer sur l'oxyde 132 une couche 210 d'un matériau à partir duquel les plots de taille nanométriques 134 doivent être formés. De manière générale, la couche 210 est constituée de silicium qui peut être amorphe, polycristallin ou monocristallin. L'invention ne fait pas non plus d'hypothèse sur le mode d'obtention de cette couche. Dans le cas de l'application de l'invention à la réalisation de grilles flottantes de mémoires non-volatiles, la couche 210 peut par exemple être constituée de silicium polycristallin déposé sur la couche d'oxyde 132. Dans ce cas, des nanocristaux métalliques assurent une meilleure rétention des électrons piégés dans chacun des sites discrets constituant la grille flottante autorisant ainsi un stockage multi niveaux avec les avantages discutés précédemment quant à la densité d'intégration des mémoires. En effet, les nanocristaux métalliques possèdent un fort travail de sortie, ce qui permet aux électrons d'être piégés plus profondément et donne des courants de fuite inférieurs à travers l'isolant. D'autre part, les métaux ayant une forte densité d'état, les nanocristaux métalliques peuvent stocker un plus grand nombre de charges comparé à des nanocristaux en silicium. Le procédé de l'invention, comme on le verra ci-après, produit de tels nanocristaux à caractère métallique en partant toutefois de silicium auquel, quand les plots nanométriques seront formés, on appliquera une étape de siliciuration à partir d'un métal comme le nickel ou le platine.

La couche 210 est donc une couche de silicium obtenue à l'aide de l'un ou l'autre des moyens de dépôt mis en oeuvre par l'industrie de la microélectronique et permettant d'obtenir du silicium polycristallin ou amorphe. Il pourra aussi s'agir d'une couche de silicium monocristallin obtenue par transfert depuis un autre substrat comme pour l'obtention des tranches de silicium sur isolant, communément appelées SOI, de l'anglais « silicon on insulator ». Dans le cadre de la mise en oeuvre de l'invention, quel que soit son mode d'obtention, son épaisseur est typiquement comprise entre 3 et 100 nm et plus particulièrement entre 5 et 60 nm et plus particulièrement entre 5 et 40 nm et plus particulièrement entre 5 et 20 nm. De préférence son épaisseur est de 10 nm Une couche d'oxyde de silicium (SiO2) 220 est ensuite disposée sur la couche de silicium 210. Elle permet le dépôt du PS-r-PMMA, constituant la couche 230 décrite ci-après, qui se greffe sur les liaisons hydroxyles Si-OH en surface du SiO2. Son épaisseur est d'au moins 2nm. Typiquement, elle est aussi déposée. D'une façon générale, tous les moyens utilisés par l'industrie de la microélectronique pour former des couches de matériaux tels que le silicium et son oxyde sont susceptibles d'être utilisés pour obtenir la structure décrite en figure 2.

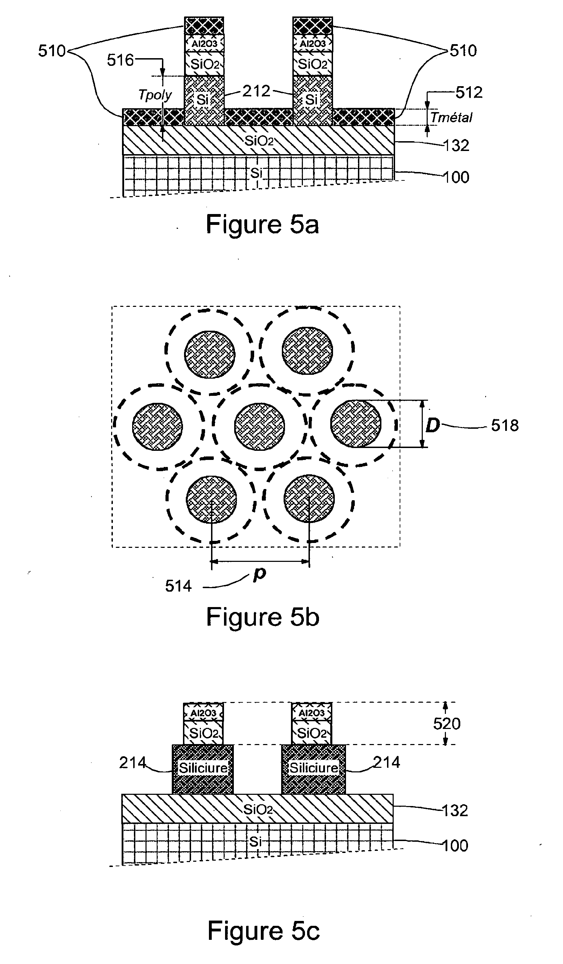

Ici il est important de remarquer que la hauteur des plots de silicium que l'on va finir de réaliser dans les étapes suivantes ne dépendra strictement et seulement que de l'épaisseur de la couche 210 de silicium créée à cette étape. Avantageusement, la dispersion en épaisseur de cette couche 210 sur l'étendue d'un substrat est négligeable. Elle est de l'ordre de quelques pourcents, ce qui contribue à l'obtention d'un réseau de plots dont les tailles et volumes individuels seront très peu dispersés comme cela sera détaillé par la suite. Or, la taille et le volume des plots sont des facteurs très importants pour le processus de siliciuration comme on le verra avec la description de la figure 5.

A ce stade, où l'on va procéder au dépôt de la couche de copolymère, il faut aussi remarquer que les énergies d'interaction du PMMA et du PS vis-à-vis de l'oxyde de silicium ne sont pas égales. Il est donc nécessaire de neutraliser la surface de la couche d'oxyde 220 afin de pouvoir effectivement obtenir un film de copolymère organisé en cylindres perpendiculaires au substrat. Pour produire ce résultat on procède d'abord à un nettoyage de type dit CARO, c'est-à-dire à l'aide d'un mélange d'acide sulfurique $H_2SO_4$ et de peroxyde d'hydrogène $H_2O_2$, traditionnellement dans une proportion de 2.5 parts de $H_2SO_4$ pour une part de $H_2O_2$,. Nettoyage qui crée des liaisons hydroxyles Si-OH en surface de l'oxyde de silicium ($SiO_2$). Comme montré sur la figure 2a une solution de copolymère est ensuite étalée par centrifugation à la tournette, également désigné « spin coating », pour former une couche copolymère statistique 230 sur la surface de la plaque où sont réalisés les dispositifs. Il s'agit d'un produit appelé PS-r-PMMA (Polystyrene-r-polymethylmethacrylate ou Polystyrene-random-polymethylmethacrylate), utilisé comme couche de neutralisation, et dont les caractéristiques sont : fraction molaire = 0,59, masse moléculaire = 13100, et indice de polymolécularité = 1,47. Il est constitué d'une alternance aléatoire de groupes PS et PMMA. Le PS-b-PMMA est le copolymère dibloc constitué d'un bloc de PMMA (succession de monomères PMMA) et d'un bloc de PS (succession de monomères PS) reliés entre eux par une liaison covalente.

Afin de favoriser l'ancrage des chaînes de copolymère aléatoires à la surface de la plaque, un recuit sous vide de 48h ou plus, à 170°C, c'est-à-dire à une température inférieure à la température de dégradation du copolymère statistique, est effectué. La durée du recuit au-delà de 48 heures n'est pas critique. Les chaînes de copolymère qui ne se sont pas fixées à la surface du SiO2 sont rincées dans un bain de toluène. Après quoi la surface du SiO2 est neutralisée pour le dépôt qui va suivre de copolymère dibloc PS-b-PMMA dont les caractéristiques sont : fraction molaire = 0,3, masse moléculaire = 67100, indice de polymolécularité = 1,09. Il est étalé à la tournette sur la couche de copolymère aléatoire précédente 230. Comme montré sur la figure 2b un recuit à 170°C sous un vide de $5\times10^{-2}$ mBar (mB = $10^{-3}$ Bar) conduit à la formation d'un film auto-organisé 240 qui comprend des cylindres verticaux de PMMA 242 dans une matrice 244 de PS.

Comme montré sur la figure 2c l'étape suivante consiste à éliminer l'un des copolymères. Dans ce mode de réalisation, cette étape consiste à éliminer les cylindres de PMMA 242 sélectivement par rapport au PS 244. Après avoir été immergé dans un bain d'acide acétique pendant une durée d'au moins trois minutes le PMMA, ainsi que les parties exposées de la couche de copolymère aléatoire sous-jacente 230, sont retirés dans un plasma d'argon et d'oxygène (Ar/O2). Tout type de réacteur de gravure plasma est susceptible de convenir pour cette opération. La figure 2c montre aussi une vue partielle en plan 201 de la matrice 244 de PS et des ouvertures cylindriques 243 restant après enlèvement du PMMA formant une structure en nid d'abeille.

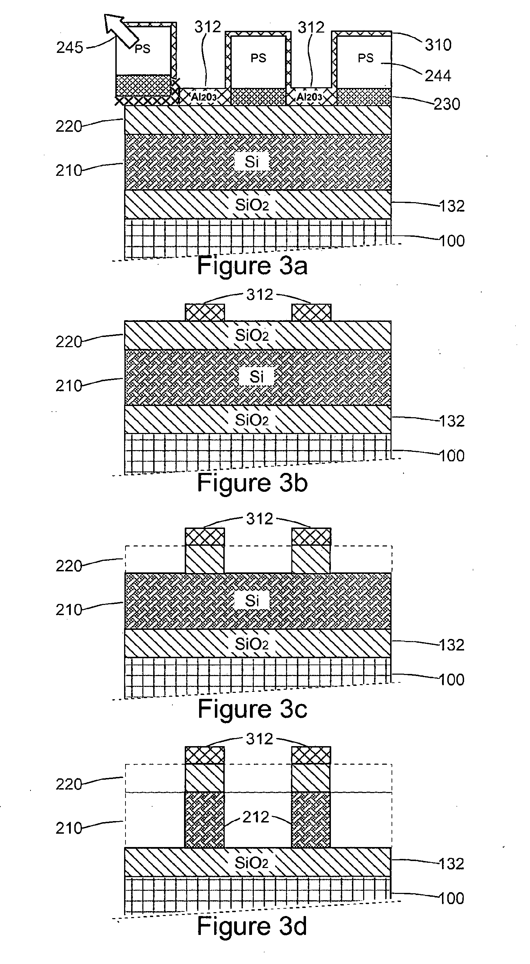

La **figure 3** comprend les **figures 3a à 3d** qui décrivent les étapes du procédé où l'on forme les plots de silicium.

Les étapes suivantes consistent en la formation d'un masque dur pour permettre la gravure des plots dans la couche de silicium 210 à partir de la matrice 244 restante de la couche en un matériau capable de s'auto organiser, c'est-à-dire ici la matrice 244 restante de polystyrène. On rappelle qu'un masque dur présente des motifs et qu'il est conformé pour résister à une gravure de la ou des couches sous jacentes de sorte à transférer les motifs du masque dans ces couches. Cette gravure peut être chimique, physique ou physico-chimique.

A cette fin, comme montré sur la **figure 3a** une couche de masquage 310, typiquement une couche d'alumine ou $Al_2O_3$ est alors déposée à basse température, typiquement à une température de l'ordre de 150°C, et en tout état de cause à une température inférieure à la température de fusion du polystyrène (PS) sous-jacent soit 240°C. Le dépôt se fait de préférence par la technique dite ALD, de l'anglais « Atomic Layer Deposition » (dépôt de couche d'épaisseur atomique) qui permet de déposer, en phase gazeuse, une couche d'épaisseur atomique à chaque cycle successif de dépôt après introduction de deux gaz dits précurseurs. Par conséquent, l'épaisseur minimale qui peut être déposée est une couche unique soit moins d'un nanomètre. L'épaisseur maximale est limitée par l'étape de décollement ou « lift-off » qui suit. Cette étape ne peut être réalisée que si l'épaisseur d'alumine déposée sur le polystyrène est suffisamment faible. L'épaisseur de la couche 310 est de quelques nanomètres ; typiquement, jusqu'à 5nm. On notera par ailleurs qu'en raison de la faible concentration de liaisons OH à la surface du polystyrène le dépôt ALD se fait de manière sélective. Un retard à la nucléation est constaté sur le polystyrène qui fait que le dépôt d'$Al_2O_3$ est plus épais au fond des ouvertures 312, là où il se forme sur la couche de $SiO_2$ 220. Ouvertures 243 laissées après enlèvement des cylindres de PMMA 242 comme on l'a vu avec la description de la figure 2c.

Le phénomène ci-dessus est favorable à la mise en oeuvre de l'invention. Une faible épaisseur d'$Al_2O_3$ est déposée, en particulier sur les flancs du PS, ce qui permet avantageusement de pratiquer un « lift-off » 245 ou soulèvement du PS sous jacent et son enlèvement en même temps que la couche PS-r-PMMA 230, à l'aide d'une gravure sèche dans un plasma, c'est-à-dire par bombardement à l'aide d'un gaz ionisé, de l'oxygène dans ce cas. Un lift-off en solution est également possible. L'échantillon est alors trempé dans un bain de solvant du polystyrène comme l'acétone ou le toluène.

D'une façon générale l'alumine de la couche 310 peut être remplacée par tout matériau susceptible d'être déposé à une température inférieure à la température de fusion du polystyrène, soit 240°C, et présentant une bonne sélectivité de gravure par rapport au silicium.

Après cette opération, où un transfert direct des motifs auto organisés est obtenu sans qu'aucunes autres étapes intermédiaires ne viennent altérer la précision de leur définition, seul un réseau de motifs cylindriques d'alumine 312 de taille nanométrique subsiste. Ce résultat est montré sur la **figure 3b.** Le réseau de motifs cylindriques d'alumine forme un masque dur pour les opérations de gravure qui suivent, c'est-à-dire notamment pour la gravure de la couche de silicium 210 sous-jacente. L'alumine est en effet connue pour être un excellent masque dur de gravure avec une forte sélectivité vis-à-vis du silicium. D'autres matériaux pourraient être utilisés pour former le masque dur, comme par exemple l'oxyde de silicium ($SiO_2$), le nitrure de silicium ($Si_3N_4$) ou le carbone amorphe.

Comme montré sur la **figure 3c** une chimie de gravure à base de $CF_4$ (plasma fluoré) est cependant d'abord utilisée pour graver la couche supérieure d'oxyde de silicium 220.

Puis, comme montré sur la **figure 3d,** une chimie plasma soit à base de $SF_6$, $CH_2F_2$, $He-O_2$, (plasma fluoré) soit à base de HBr, $CL_2$, Ar (plasma à base de brome et de chlore) est employée pour graver la couche de silicium. Ces deux types de chimies conviennent bien pour la gravure des grilles en silicium polycristallin des transistors MOSFET.

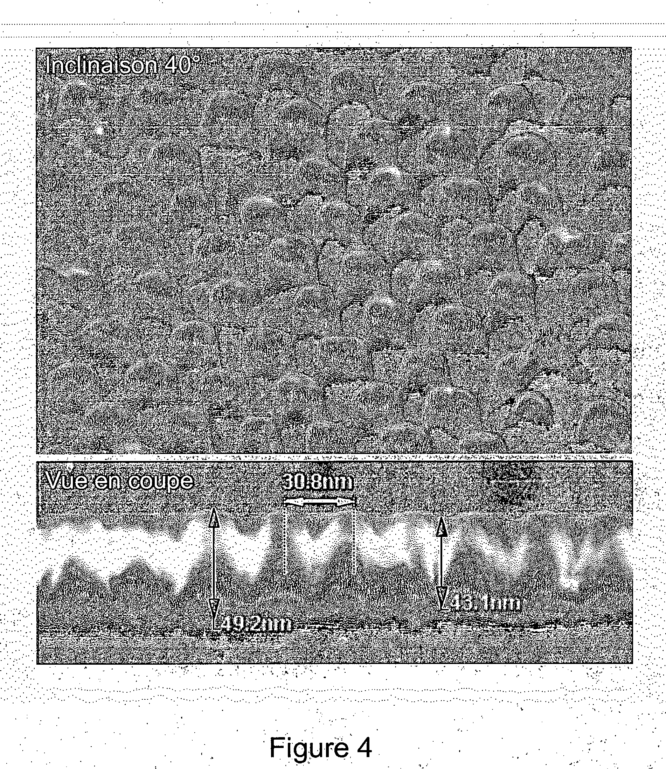

La gravure précédente s'arrête sur une couche d'arrêt. Dans cet exemple, il s'agit de la couche d'oxyde 132 qui constitue la couche d'oxyde tunnel dans le cas où le procédé est utilisé pour la réalisation de grilles flottantes comme on l'a vu précédemment. Toute couche dont la gravure est sélective par rapport à la chimie de gravure du silicium est susceptible de convenir. On obtient ainsi un réseau de plots nanométriques 212 en silicium ayant une faible dispersion en surface, en espacement et en hauteur comme cela peut être observé, en coupe et avec une inclinaison de 40° sur la photo de la **figure 4** réalisée à l'aide d'un microscope à balayage électronique. Typiquement, des plots nanométriques également désignés nanoplots sont des structures dont la hauteur est comprise entre plusieurs dizaines de nanomètres et quelques nanomètres. Par exemple, ces plots, de section sensiblement circulaire ou polygonale et est comprise entre 3 et 100 nanomètres et plus particulièrement entre 5 et 60 nanomètres et plus particulièrement entre 5 et 40 nanomètres et plus particulièrement entre 5 et 20 nanomètres.

La dispersion en surface et en espacement est entièrement contrôlée par le processus de formation du réseau auto organisé à partir d'un copolymère tel que le PS-PMMA. La dispersion est très faible. Un écart-type de l'ordre de 2nm est observé. Par ailleurs, en prévoyant un transfert des motifs 243 dans un masque dur pour ultérieurement graver la couche 210 de formation des plots 212, l'invention permet de ne faire dépendre la dispersion en hauteur que de la hauteur de cette même couche 210 de formation des plots. Les causes de dispersion de hauteur sont donc significativement limitées. De plus l'étape de dépôt de cette couche 210 peut être précisément contrôlée. Il en résulte une maîtrise améliorée de la hauteur des plots.

La **figure 5** comprend les **figures 5a à 5c** qui décrivent les étapes du procédé où l'on réalise la siliciuration des plots de silicium.

A l'issue de l'application des étapes décrites dans les figures précédentes on obtient, comme on vient de le voir, des plots de silicium très peu dispersés en surface, espacement et hauteur et donc en volume. La quantité de silicium étant maîtrisée il est alors possible d'ajuster précisément la quantité de métal qu'il faut apporter pour atteindre la phase de siliciuration souhaitée. Les relations existant entre les épaisseurs de métal déposé, de silicium consommé et de siliciure formé doivent pour cela être connues. Les deux métaux choisis comme exemple de mise en oeuvre de l'invention sont le platine (Pt) et le nickel (Ni) dont les changements volumiques dans le cas d'une couche continue sont connus et reportés dans le tableau ci-après. La colonne de droite de ce tableau indique si un retrait sélectif du métal en excès après siliciuration est possible ou non, c'est-à-dire s'il existe ou non une chimie connue de gravure permettant de retirer le métal sans attaquer le siliciure. Platine et nickel sont donnés à titre d'exemples ; tous les siliciures métalliques sont susceptibles de convenir entre autres ceux formés avec les métaux correspondants aux symboles chimiques suivant : Ti, V, Cr, Mn, Fe, Co, Mo, Pd, Ta et W.

| Métal Volume | Silicium Volume | Phase du Siliciure Volume | Retrait sélectif du métal / siliciure |
|:---:|:---:|:---:|:---:|
| Ni 1 | Si 1.84 | NiSi 2.2 | Oui |
| Ni 1 | Si 0.9 | $Ni_2Si$ 1.5 | Oui |
| Pt 1 | Si 1.3 | PtSi 2 | Oui |
| Pt 1 | Si 0.66 | $Pt_2Si$ 1.51 | Non |

Avant le dépôt de métal les plots nanométriques sont nettoyés afin de retirer l'oxyde natif et les polymères résiduels de la gravure sèche qui seraient une barrière à la siliciuration. La quantité de métal à déposer sur les plots doit donc être proportionnelle au volume des plots de silicium dans un rapport mentionné dans le tableau ci-dessus. Le dépôt de métal 510, comme montré sur la **figure 5a,** est de préférence non-conforme. C'est-à-dire que le dépôt ne se fait pas, ou peu sur les flancs des gravures. Pour ce faire, une technique de type dit PVD, de l'anglais « Physical Vapor Deposition » soit dépôt physique en phase vapeur, est utilisée. Ce terme recouvre une variété de techniques de dépôts de films minces sous vide par simple évaporation thermique d'une source, ou par pulvérisation cathodique encore appelé « sputtering ».

Comme montré sur la **figure 5b** le métal utile pour la siliciuration est un anneau de diamètre $p$ correspondant à la période de répétition 514 d'un réseau hexagonal de plots. En effet, lorsque la composition du copolymère devient asymétrique, c'est-à-dire pour des fractions volumiques PMMA/(PMMA+PS) inférieures à 0.5, il devient énergétiquement favorable que l'interface entre le PMMA et le PS se courbe. Cela produit un réseau hexagonal. L'avantage de ce type de réseau est sa compacité : c'est le réseau hexagonal qui donne une densité de plots maximale pour un diamètre de plot donné. Comme montré sur la figure 5a, l'épaisseur de métal déposé 512, est notée *Tmétal.* Comme mentionné ci-dessus, dans le cas d'un dépôt non-conforme, il n'y a quasiment pas de dépôt sur les flancs des plots 212 en silicium. L'épaisseur de métal à déposer est donc donnée par la formule suivante :

$$Tmétal = \frac{Tpoly\,\pi\left(\dfrac{D}{2}\right)^2}{\pi\left(\dfrac{p}{2}\right)^2 - \pi\left(\dfrac{D}{2}\right)^2}\,\alpha_{poly/métal}$$

On notera que le terme $\alpha_{poly/métal}$ correspond au rapport volume de silicium sur volume de métal nécessaire pour obtenir la phase du siliciure visée conformément au tableau précédent. Par exemple, pour obtenir NiSi, $\alpha_{poly/métal}$ = 1/1.84 = 0.54

Dans la formule ci-dessus *Tpoly* 516 est la hauteur des nanoplots de silicium, $p$ est, comme on l'a vu, la période du réseau hexagonal de nanoplots 514, et $D$ est le diamètre des nanoplots 518. Ainsi, il est possible de calculer l'épaisseur de métal à déposer connaissant la largeur et la hauteur des plots de silicium. Les valeurs obtenues dans le cas du PtSi et du NiSi avec $D$ = 20nm, $p$ = 40nm et $Tpoly$ =15nm sont reportées dans le tableau ci-après.

| Phase visée | PtSi | Pt$_2$Si | NiSi | Ni$_2$Si |
|---|---|---|---|---|
| Épaisseur de métal à déposer (pour une épaisseur $Tpoly$= 15nm) | 3,8 nm | 7,6 nm | 2,7 nm | 5,6 nm |

Dans le cas d'un dépôt conforme de métal du type CVD, de l'anglais « Chemical Vapor Déposition » c'est-à-dire dépôt chimique en phase vapeur; technique faisant intervenir différents types de réactions chimiques dans une chambre de déposition, la totalité des flancs des plot de silicium est alors recouverte de métal. Dans ce cas, qui n'est pas représenté sur la figure 5, il faut utiliser une autre méthode de calcul de l'épaisseur à déposer. Méthode de calcul qui est facilement dérivée par l'homme du métier de la méthode précédente.

Une fois le métal déposé par PVD ou par CVD, un recuit de siliciuration sous vide est réalisé. Dans le cas du platine et du nickel, un recuit à 400°C pendant environ une minute sous vide permet d'atteindre l'équilibre de siliciuration, c'est-à-dire le point où il y a eu consommation totale d'un des deux réactants : le silicium ou le métal.

Plus précisément, le tableau suivant indique quelques exemples de phases alliées (siliciure) formées entre un métal et le silicium avec la température de formation du siliciure et sa valeur de résistivité :

| Elément (A) | Siliciure (A-Si) | Température de formation (°C) | Résistivité ($10^{-6}$ ohm.cm) |
|---|---|---|---|
| Ti | TiSi<br>TiSi$_2$ | 500<br>600 | 63 $\pm$ 6<br>10-25 |
| V | VSi$_2$ | 600 | 50-55 |
| Cr | CrSi$_2$ | 450 | >250-1420 |
| Mn | MnSi<br>MnSi$_2$ | 400-500<br>800 | 200-260<br>6500-13000 |
| Fe | FeSi<br>FeSi$_2$ | 450-550<br>550 | 260-290<br>- |
| Co | Co$_2$Si<br>CoSi<br>CoSi$_2$ | 350-500<br>375-500<br>550 | 60-130<br>90-170<br>18-65 |
| Ni | Ni$_2$Si<br>NiSi<br>NiSi$_2$ | 200-350<br>350-750<br>$\geq$750 | 20-25<br>14-50<br>34-60 |
| Mo | MoSi$_2$ | 525 | 21-200 |
| Pd | Pd$_2$Si<br>PdSi | 100-300<br>850 | 25-35<br>- |
| Ta | TaSi$_2$ | 650 | 8.5-55 |
| W | WSi$_2$ | 650 | 50-200 |
| Pt | Pt$_2$si<br>PtSi | 200-500<br>300 | -<br>28-40 |

Le métal qui n'aurait pas totalement réagi avec le silicium est retiré par gravure humide grâce à une chimie sélective adaptée. Dans le cas du platine ou du nickel, on emploie de préférence l'eau régale dont la composition est : acide nitrique HNO$_3$, acide chlorydrique HCl, dans un rapport de un volume d'HNO3 pour deux à trois volumes d'HCl. On obtient ainsi le résultat montré sur la **figure 5c** où les plots de silicium ont été siliciurés 214 et ont donc augmentés de volume.

À ce stade il convient de remarquer qu'il est généralement plus simple et sans inconvénient de laisser le SiO2 et l'Al2O3 520 au sommet des plots 214. En particulier, dans le cadre de l'utilisation du procédé de l'invention pour la réalisation de transistors MOSFET à grille flottante comme décrit en figure 1, cela n'est pas gênant car les nanocristaux seront ensuite encapsulés dans le diélectrique de contrôle 136, lui-même constitué de SiO2, de Si3N4 ou d'oxydes métalliques tels que l'Al2O3 et l'HfO2.

La réalisation de plots nanométriques siliciurés selon l'invention met en exergue l'avantage très important que constitue pour la siliciuration l'obtention préalable de plots dont volumes et espacements sont très peu dispersés quand on compare ce procédé à un mode de réalisation traditionnel.

Si l'on dépose des nanocristaux de silicium sur une surface de $SiO_2$, à l'aide par exemple d'une technique dite LPCVD de l'anglais « Low Pressure Chemical Vapor Deposition » soit dépôt chimique en phase vapeur à basse pression. On peut déposer ensuite une couche continue, par exemple, de platine, et l'on peut obtenir deux phases de siliciuration du platine : PtSi et Pt2Si. Les plaques subissent un recuit de siliciuration afin d'atteindre la phase PtSi. Il est dans ce cas très important de ne pas atteindre la phase Pt2Si. En effet, la couche résiduelle de platine entre les plots, qui n'a pas été consommée lors de la siliciuration, est ensuite retirée à l'eau régale, qui est sélective vis-à-vis de la phase PtSi, mais pas vis-à-vis de la phase Pt2Si. Par conséquent, les nanocristaux de petites tailles sont attaqués lors du retrait sélectif.

La dispersion, en taille et en espacement, des nanocristaux obtenus par LPCVD rend ainsi difficile, voire impossible, le contrôle de la siliciuration. En effet, afin d'atteindre la phase visée du siliciure, il est nécessaire de déposer une quantité de métal juste nécessaire. Quantité juste nécessaire qui dépend étroitement du volume et de l'espacement des nanocristaux à siliciurer. Par conséquent, le siliciure formé dans les nanocristaux ne sera pas toujours identique en raison de ces dispersions.

En d'autres termes, pour un métal quelconque appelé Me, et possédant deux phases de siliciuration, Me2Si et MeSi, si l'on ajuste la quantité de métal déposé en fonction de la taille et de l'espacement moyens, les nanocristaux dont la taille est inférieure à la taille moyenne seront en Me2Si (excès de métal) tandis que les nanocristaux de taille supérieure à la moyenne posséderont un coeur non siliciuré et une coquille en MSi (excès de silicium). Or, les différentes phases de siliciures ne possèdent pas les mêmes caractéristiques électriques, notamment leur travail de sortie peut différer sensiblement et entraîner une importante variabilité des paramètres électriques des dispositifs incluant ces nanocristaux, en plus de la variabilité due à la taille physique des nanocristaux.

En améliorant en particulier la maîtrise du volume des plots nanométriques, la présente invention permet ainsi d'accroître significativement les performances et la reproductibilité des dispositifs intégrant des nanocristaux.

**Revendications**

1. Procédé d'obtention d'un réseau de plots nanométriques (212) pour dispositif microélectronique, **caractérisé en ce qu'**il comprend les étapes suivantes :

   - le dépôt d'une couche de silicium (210) sur un substrat (100, 132),
   - la formation au dessus de la couche de silicium (210) d'une couche (240) en un matériau capable de s'auto organiser dans laquelle au moins un polymère forme sensiblement des cylindres (242) organisés en un réseau au sein d'une matrice (244),
   - la formation de motifs (243) dans la couche (240) en un matériau capable de s'auto organiser par élimination desdits cylindres (242),
   - la formation d'un masque dur (312) par transfert desdits motifs (243),
   - l'obtention de plots de silicium (212) dans la couche de silicium (210) par gravure avec le masque dur (312),
   - la siliciuration des plots de silicium (212) comprenant le dépôt d'une couche de métal (510).

2. Procédé selon la revendication précédente dans lequel le substrat (100, 132) comprend un substrat de base (100) surmonté d'une couche d'oxyde de silicium (132).

3. Procédé selon l'une quelconque des revendications précédentes dans lequel la couche (240) en un matériau capable de s'auto organiser est une couche comprenant des copolymères aptes à s'auto-organiser en un réseau hexagonal plan de cylindres (242) de section sensiblement circulaire ou polygonale dans une matrice (244).

4. Procédé selon l'une quelconque des revendications précédentes dans lequel la couche (240) en un matériau capable de s'auto organiser est une couche comprenant l'un parmi : le polystyrène-poly methylmethacrylate (PS-PMMA), le polystyrène-polyvinylpyridine (PS-PVP), le polystyrène-polyethylene oxide (PS-PEO).

5. Procédé selon l'une quelconque des revendications précédentes dans lequel la couche (240) en un matériau capable de s'auto organiser est une couche comprenant du polystyrène-polymethylmethacrylate (PS-PMMA) formant des cylindres (242) de polymethylmethacrylate (PMMA) dans une matrice (244) de polystyrène (PS) et dans lequel l'étape de formation des motifs (243) comprend l'élimination sélective des cylindres (242) de PMMA par rapport à la matrice de polystyrène (PS).

**6.** Procédé selon l'une quelconque des revendications précédentes dans lequel la formation du masque dur (312) est obtenue par une étape de dépôt d'une couche de masquage (310) au moins dans les motifs (243) de la couche (240) en un matériau capable de s'auto organiser et par une étape de retrait du matériau capable de s'auto organiser en dehors des motifs (243).

**7.** Procédé selon la revendication précédente dans lequel la couche de masquage (310) est une couche résistant à une étape de gravure de sorte à protéger de la gravure des couches sous jacentes (220, 210, 132, 100) à celle de la couche de masquage (310) et à transférer les motifs du masque dur (132) dans ces couches sous jacentes.

**8.** Procédé selon l'une quelconque des deux revendications précédentes dans lequel la couche de masquage (310) est une couche prise parmi : une couche d'alumine (310), une couche d'oxyde de silicium (SiO2), une couche de nitrure de silicium (Si3N4), une couche de carbone amorphe.

**9.** Procédé selon l'une quelconque des trois revendications précédentes dans lequel l'étape de formation du masque dur (312) comprend une étape de dépôt d'une couche de masquage (310) par déposition de couches atomique.

**10.** Procédé selon l'une quelconque des quatre revendications précédentes dans lequel l'étape de formation du masque dur (312) est effectuée de sorte que le masque dur (312) présente une épaisseur d'environ 5 nanomètres.

**11.** Procédé selon l'une quelconque des cinq revendications précédentes dans lequel ladite étape de retrait du matériau (240) capable de s'auto organiser comprend une étape de soulèvement.

**12.** Procédé selon la revendication précédente comprenant préalablement à la formation d'une couche (240) en un matériau capable de s'auto organiser, une étape de formation d'une couche de neutralisation (230) en un copolymère statistique, dans lequel l'étape de formation de motifs (243) dans la couche (240) en un matériau capable de s'auto organiser conduit également à obtenir lesdits motifs (243) dans la couche de neutralisation (230), et dans lequel l'étape de soulèvement comprend le soulèvement par gravure de la couche (240) en un matériau capable de s'auto organiser et de la couche de neutralisation (230) conduisant au soulèvement de la couche de masquage (310).

**13.** Procédé selon la revendication précédente dans lequel le copolymère statistique est du Polystyrene-r-polymethylmethacrylate (PS-r-PMMA).

**14.** Procédé selon l'une quelconque des revendications précédentes comprenant, préalablement à la formation d'une couche (240) en un matériau capable de s'auto organiser, une étape de formation d'une couche d'oxyde de silicium (SiO2) recouvrant la couche de silicium (210).

**15.** Procédé selon l'une quelconque des revendications précédentes dans lequel la couche de métal (510) est constituée au moins partiellement d'un matériau pris parmi : le platine, le nickel, le titane (Ti), le vanadium (V), le chrome (Cr), le manganèse (Mn), le fer (Fe), le cobalt (Co), le molybdène (Mo), le palladium (Pd), le tantal (Ta), le tungstène (W).

**Patentansprüche**

**1.** Verfahren zum Erhalt eines Netzes aus nanometrischen Plättchen (212) für eine mikroelektronische Vorrichtung, **dadurch gekennzeichnet, dass** es die folgenden Stufen umfasst:

- Ablagerung einer Siliziumschicht (210) auf einem Substrat (100, 132),
- oberhalb der Siliziumschicht (210) die Bildung einer Schicht (240) aus einem Material, das in der Lage ist, sich selbst zu organisieren und in der wenigstens ein Polymer deutlich Zylinder (242) bildet, die in einem Netz innerhalb einer Matrix (244) organisiert sind,
- die Bildung von Motiven (243) in der Schicht (240) aus einem Material, das in der Lage ist, sich per Eliminierung der genannten Zylinder (242) selbst zu organisieren,
- die Bildung einer harten Maske (312) per Transfer der genannten Motive (243),
- den Erhalt von Siliziumplättchen (212) in der Siliziumschicht (210) per Gravur mit der harten Maske (312),
- die Silicidierung der Siliziumplättchen (212), umfassend die Ablagerung einer Metallschicht (510).

**2.** Verfahren gemäß dem voranstehenden Anspruch, bei dem das Substrat (100, 132) ein von einer Siliziumoxidschicht (132) überlagertes Basissubstrat (100) umfasst.

3. Verfahren gemäß einem der voranstehenden Ansprüche, bei dem die Schicht (240) aus einem Material, das in der Lage ist, sich selbst zu organisieren, eine Schicht ist, umfassend Kopolymere, die geeignet sind, sich selbst in einem ebenen, sechseckigen Netz aus Zylindern (242) mit deutlich kreisrundem oder polygonalen Querschnitt in einer Matrix (244) zu organisieren.

4. Verfahren gemäß einem der voranstehenden Ansprüche, bei dem die Schicht (240) aus einem Material, das in der Lage ist, sich selbst zu organisieren, eine Schicht ist, umfassend eines von: Polystyrol-Poly Methylmethacrylat (PS-PMMA), Polystyrol-Polyvinylpyridin (PS-PVD), Polystyrol-Polyethylenoxid (PS-PEO).

5. Verfahren gemäß einem der voranstehenden Ansprüche, bei dem die Schicht (240) aus einem Material, das in der Lage ist, sich selbst zu organisieren, eine Schicht ist, umfassend Polystyrol-Polymethylmethacrylat (PS-PMMA), das Zylinder (242) aus Polymethylmethacrylat (PMMA) in einer Matrix (244) aus Polystyrol (PS) bildet und in dem die Bildungsstufe der Motive (243) die selektive Eliminierung der Zylinder (242) aus PMMA im Verhältnis zur Matrix aus Polystyrol (PS) umfasst.

6. Verfahren gemäß einem der voranstehenden Ansprüche, bei dem die Bildung der harten Maske (312) durch eine Ablagerungsstufe einer Abdeckschicht (310) wenigstens in den Motiven (243) der Schicht (240) aus einem Material erhalten wird, das in der Lage ist, sich selbst zu organisieren, und durch eine Abnahmestufe des Materials, das in der Lage ist, sich außerhalb der Motive (243) selbst zu organisieren.

7. Verfahren gemäß dem voranstehenden Anspruch, bei dem die Abdeckschicht (310) eine einer Gravurstufe widerstehende Schicht derart ist, dass die unter der Abdeckschicht (310) liegende Schichten (220, 210, 132, 100) vor der Gravur geschützt werden und die Motive der harten Maske (132) in diese darunterliegenden Schichten übertragen werden.

8. Verfahren gemäß einem der zwei voranstehenden Ansprüche, bei dem die Abdeckschicht (310) eine Schicht ist, die genommen ist aus: einer Tonerdeschicht (310), einer Schicht aus Siliziumoxid (SiO2), einer Schicht aus Siliziumnitrid (Si3N4), einer Schicht aus amorphem Kohlenstoff.

9. Verfahren gemäß einem der drei voranstehenden Ansprüche, bei dem die Bildungsstufe der harten Maske (312) eine Ablagerungsstufe einer Abdeckschicht (310) per Ablagerung von Atomschichten umfasst.

10. Verfahren gemäß einem der vier voranstehenden Ansprüche, bei dem die Bildungsstufe der harten Maske (312) derart durchgeführt wird, dass die harte Maske (312) eine Dicke von ungefähr 5 Nanometern aufweist.

11. Verfahren gemäß einem der fünf voranstehenden Ansprüche, bei dem die genannte Abnahmestufe des Materials (240), das in der Lage ist, sich selbst zu organisieren, eine Abhebestufe umfasst.

12. Verfahren gemäß dem voranstehenden Anspruch, umfassend vor der Bildung einer Schicht (240) aus einem Material, das in der Lage ist, sich selbst zu organisieren, eine Bildungsstufe einer Neutralisationsschicht (230) aus einem statistischen Kopolymer, bei dem die Bildungsstufe von Motiven (243) in der Schicht (240) aus einem Material, das in der Lage ist, sich selbst zu organisieren, ebenfalls zum Erhalt der genannten Motive (243) in der Neutralisationsschicht (230) führt und bei dem die Abhebestufe das Abheben per Gravur der Schicht (240) aus einem Material, das in der Lage ist, sich selbst zu organisieren, und der Neutralisationsschicht (230) umfasst, die zum Abheben der Abdeckschicht (310) führt.

13. Verfahren gemäß dem voranstehenden Anspruch, bei dem das statistische Kopolymer Polystyrol-r-Polymethylmethacrylat (PS-r-PMMA) ist.

14. Verfahren gemäß einem der voranstehenden Ansprüche, umfassend vor der Bildung einer Schicht (240) aus einem Material, das in der Lage ist, sich selbst zu organisieren, eine Bildungsstufe eine die Siliziumschicht (210) abdeckenden Siliziumoxidschicht (SiO2) bildet.

15. Verfahren gemäß einem der voranstehenden Ansprüche, bei dem die Metallschicht (510) wenigstens teilweise aus einem Material gebildet ist, das genommen ist aus: Platin, Nickel, Titan (Ti), Vanadium (V), Chrom (Cr), Mangan (Mn), Eisen (Fe), Kobalt (Co), Molybdän (Mo), Palladium (Pd), Tantal (Ta), Wolfram (W).

**Claims**

1. A method for obtaining a network of nanometric terminals (212) for a microelectronic device, **characterized in that** it comprises the following steps:

   - depositing a silicon layer (210) on a substrate (100, 132),
   - forming, above the silicon layer (210), a layer (240) in a material able to self-organize, wherein at least a polymer substantially forms cylinders (242) organized in a network within an array (244),
   - forming patterns (243) in the layer (240) of a material able to self-organize through the removing of said cylinders (242),
   - forming a hard mask (312) by transferring said patterns (243),
   - obtaining silicon terminals (212) in the silicon layer (210) by etching with the hard mask (312),
   - silicidation the silicon terminals (212) comprising depositing a metal layer (510).

2. A method according to the preceding claim, wherein the substrate (100, 132) comprises a base substrate (100) topped by a silicon oxide layer (132).

3. A method according to any one of the preceding claims, wherein the layer (240) made of a material able to self-organize is a layer comprising copolymers able to self-organize into a plane hexagonal network of cylinders (242) having a substantially circular or polygonal section in an array (244).

4. A method according to any one of the preceding claims, wherein the layer (240) made of a material able to self-organize is a layer comprising one of: polystyrene-polymethylmethacrylate (PS-PMMA), polystyrene-polyvinylpyridine (PS-PVP), polystyrene-polyethylene oxide (PS-PEO).

5. A method according to any one of the preceding claims, wherein the layer (240) made of a material able to self-organize is a layer comprising polystyrene-polymethylmethacrylate (PS-PMMA), forming cylinders (242) of polymethylmethacrylate (PMMA) in an array (244) of polystyrene (PS), and wherein the step of forming the patterns (243) comprises the selective removing of the PMMA cylinders (242) relative to the polystyrene (PS) array.

6. A method according to any one of the preceding claims, wherein forming the hard mask (312) is obtained during a step of depositing a masking layer (310) at least in the patterns (243) of the layer (240) made of a material able to self-organize and during a step of removing the material able to self-organize outside the patterns (243).

7. A method according to the preceding claim, wherein the masking layer (310) is a layer which can resist a step of etching so as to protect from etching the layers (220, 210, 132, 100) underlying the masking layer (310) and to transfer the patterns of the hard mask (132) into such underlying layers.

8. A method according to any one of the preceding two claims wherein the masking layer (310) is a layer selected among: an alumina layer (310), a silicon oxide layer (SiO2), a silicon nitride layer (Si3N4), an amorphous carbon layer.

9. A method according to any one of the preceding three claims, wherein the step of forming the hard mask (312) comprises a step of depositing a masking layer (310) by atomic layer deposition.

10. A method according to any one of the preceding four claims, wherein the step of forming the hard mask (312) is executed so that the hard mask (312) has a thickness of about 5 nanometres.

11. A method according to any one of the preceding five claims, wherein said step of removing the material (240) able to self-organize comprises a lift-off step.

12. A method according to the preceding claim comprising, prior to forming a layer (240) in a material able to self-organize, a step of forming a neutralization layer (230) in a random copolymer, wherein the step of forming the patterns (243) in the layer (240) made of a material able to self-organize also leads to obtaining said patterns (243) in the neutralization layer (230), and wherein the lift-off step comprises the lift-off by etching the layer (240) made of a material able to self-organize and the neutralization layer (230) leading to the lift-off of the masking layer (310).

13. A method according to the preceding claim, wherein the random copolymer is polystyrene-r-polymethylmethacrylate (PS-r-PMMA).

**14.** A method according to any one of the preceding claims, comprising, prior to forming a layer (240) in a material able to self-organize, a step of forming a silicon oxide layer (SiO2) covering the silicon layer (210).

**15.** A method according to any one of the preceding claims, wherein the metal layer (510) at least partially consists of a material selected from: platinum, nickel, titanium (Ti), vanadium (V), chromium (Cr), manganese (Mn), iron (Fe), cobalt (Co), molybdenum (Mo), palladium (Pd), tantalum (Ta), tungsten (W).

Figure 1

230 — PS-r-PMMA

PS

PMMA

OH OH   OH OH   OH OH   OH OH   OH OH   OH OH

220 — SiO₂

210 — Si

SiO₂ — 132

— 100

## Figure 2a

244 — 242 — 244

PS | PMMA | PS | PMMA | PS — 240

230 — PS-r-PMMA

220 — SiO₂

210 — Si

SiO₂ — 132

— 100

## Figure 2b

244

PS | PS | PS

230 —

220 — SiO₂

210 — Si

SiO₂ — 132

— 100

201

243

244

## Figure 2c

Figure 3a

Figure 3b

Figure 3c

Figure 3d

Figure 4

Figure 5a

Figure 5b

Figure 5c

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20040256662 A